# FASCICULE DE BREVET EUROPEEN

(11) **EP 1 409 406 B1**
(45) Date de publication et mention de la délivrance du brevet: **02.01.2008**
(21) Numéro de dépôt: 02767591.7
(22) Date de dépôt: 22.07.2002
(51) Int. Cl.: C01B 33/037, C01B 33/025

(54) **SILICIUM METALLURGIQUE DE MOYENNE PURETE ET PROCEDE D'ELABORATION**
METALLURGISCHES SILIZIUM MITTLERERER REINHEIT UND VERFAHREN ZU SEINER HERSTELLUNG
MEDIUM PURITY METALLURGICAL SILICON AND METHOD FOR PREPARING SAME

(30) Priorité: 23.07.2001 FR 0109788
(43) Date de publication de la demande: 21.04.2004
(73) Titulaire: FERROPEM, 73000 Chambery (FR)
(72) Inventeur: BALUAIS, Gérard, F-74190 Chedde (FR); CARATINI, Yves, F-74190 Chedde (FR)
(74) Mandataire: Maureau, Philippe
(86) Numéro de dépôt international: PCT/FR2002/002603
(87) Numéro de publication internationale: WO 2003/010090

(56) Documents cités:
- EP-A- 0 477 784
- EP-A- 0 720 967
- DE-A- 3 439 550
- US-A- 4 193 975
- US-A- 4 837 376
- DATABASE WPI Section Ch, Week 199234 Derwent Publications Ltd., London, GB; Class E36, AN 1992-281549 XP002194088 & JP 04 193706 A (KAWASAKI STEEL CORP), 13 juillet 1992 (1992-07-13)

## Description

### Domaine de l'invention

L'invention concerne un silicium métallurgique de moyenne pureté destiné à servir de matière première à la fabrication de silicium de qualité électronique ou de qualité photovoltaïque. L'invention concerne également le procédé d'élaboration de ce matériau.

### Etat de la technique

Les utilisations du silicium sont multiples et requièrent chacune des spécifications particulières. Pour les applications électronique et photovoltaïque qui exigent des niveaux de pureté élevés, la filière de production des produits finis tels que les cellules photoélectriques ou les panneaux solaires, comporte une étape d'élaboration de silicium pur à partir d'un matériau de base, qui est un silicium essentiellement à basse teneur en bore et phosphore.

Les produits déclassés issus de la fabrication de silicium électronique ont constitué pendant longtemps la principale source de silicium photovoltaïque, mais cette source s'avère insuffisante pour fournir la demande croissante du marché. Ceci nécessite de se tourner vers d'autres sources de silicium, comme le silicium métallurgique élaboré par réduction carbothermique de la silice au four électrique à arc submergé, dont on peut améliorer la qualité par divers traitements d'affinage en métallurgie secondaire, par exemple l'affinage au chlore décrit dans le brevet EP 0.720.967 (Pechiney Electrométallurgie). On fabrique ainsi un silicium pouvant répondre à des spécifications telles que par exemple (% en poids) :
fer < 0,30% calcium < 0,10% aluminium < 0,30%
bore : 20 à 50 ppm phosphore : 20 à 100 ppm.

La teneur en phosphore dépend beaucoup des réducteurs utilisés. Avec le charbon de bois, on peut facilement obtenir du silicium dont la teneur en phosphore se situe vers 50 ppm; ce type de silicium est plutôt utilisé pour la fabrication des silicones. Avec les réducteurs fossiles, on peut produire un silicium dont la teneur en phosphore est inférieure à 25 ppm, et dont la principale application est la fabrication des alliages aluminium - silicium. Ces deux qualités restent cependant très éloignées du niveau de pureté requis pour les applications électronique et photovoltaïque.

La solidification ségrégée, connue depuis fort longtemps permet dans le cas du silicium, d'abaisser les teneurs en impuretés de nombreux éléments. Cette technique est cependant inefficace pour atteindre les niveaux de pureté demandés en bore et phosphore en partant des deux qualités indiquées ci-dessus.

Ainsi sous la pression d'une demande croissante du marché, un effort important de recherche a été entrepris pour élaborer un silicium à basse teneur en bore et phosphore à partir de silicium métallurgique, en utilisant notamment la purification du silicium fondu sous plasma.

Le brevet FR 2585690 de Rhône-Poulenc Spécialités Chimiques décrit un affinage en deux temps, comprenant une fusion sous plasma avec comme gaz plasmagène un mélange hydrogène-argon, puis un affinage sous plasma avec comme gaz un mélange hydrogène-argon-oxygène.

Le brevet EP 0.459.421 (Kawasaki Steel) décrit l'affinage du silicium par plasma en creuset siliceux, ou revêtu d'un garnissage réfractaire siliceux, en utilisant comme gaz plasmagène un gaz inerte additionné de 0,1 à 10% de vapeur d'eau, et, de façon facultative, de poudre de silice dans une proportion inférieure à 1 kg de silice par Nm³ de gaz.

Le brevet FR 2.772.741 du CNRS décrit un affinage du silicium liquide avec un mélange gazeux chlore-hydrogène-vapeur d'eau.

Ces techniques de traitement sous plasma ont été conçues à une échelle de laboratoire et leur transposition à l'échelle industrielle est rendue difficile par les difficultés techniques rencontrées pour construire des outils de taille plus importante.

L'invention a ainsi pour but d'obtenir un silicium de pureté moyenne à faible teneur en bore et en phosphore à partir de silicium métallurgique en restant dans les techniques de l'électrométallurgie.

### Objet de l'invention

L'invention a pour objet un procédé de fabrication d'un silicium de moyenne pureté comprenant :
- l'élaboration, par réduction carbothermique de la silice au four électrique à arc submergé, d'un silicium à basse teneur en bore, en utilisant des réducteurs à teneur en bore <2 ppm et présentant une surface spécifique moyenne pondérée 5 comprise entre 20 et 40 m²/g, la densité de puissance utilisée, exprimée par le rapport (Pe/D₀³)/3, étant comprise entre 2 et 3 MW/m³,
- l'affinage du silicium liquide à l'oxygène ou au chlore,
- le traitement du silicium affiné sous pression réduite de 10 à 100 Pa avec injection de gaz neutre,
- une solidification ségrégée.

Cette solidification ségrégée peut, si nécessaire, être réitérée après une refusion, par exemple en four à induction.

### Description de l'invention

Les techniques habituelles d'affinage utilisées en électrométallurgie ne permettent pas de réduire significativement la teneur en bore du silicium. C'est pourquoi la demanderesse a eu l'idée de fabriquer un silicium à basse teneur en bore simplement en sélectionnant des matières premières adéquates pour effectuer la réduction carbothermique de la silice au four électrique.

Cette voie, pour simple qu'elle puisse paraître, n'a pas jusqu'à maintenant été utilisée car elle présente une difficulté majeure : on ne connaît pas de réducteurs à basse teneur en bore présentant une réactivité suffisante pour permettre leur emploi au four électrique.

Pour le quartz, il suffit de sélectionner le matériau sur la base des critères habituels connus de l'homme de l'art, par exemple une teneur en SiO₂ supérieure à 98% et une teneur en éléments alcalins aussi faible que possible, critères auxquels on ajoute une teneur en bore inférieure à 5 ppm.

La difficulté se situe au niveau du choix des réducteurs. Il faut obligatoirement sélectionner un ou plusieurs réducteurs pouvant être utilisés en mélange avec une teneur en bore inférieure à 2 ppm, et de préférence inférieure à 1 ppm. De nombreux cokes de pétrole, ainsi que certains cokes de brai répondent à cette spécification, mais tous ces produits ont en commun d'être peu réactifs au four électrique, et aucun d'eux ne permet un fonctionnement normal du four électrique dans le cas d'une réduction carbothermique de la silice pour conduire au silicium.

En analysant ce problème de plus près, la demanderesse a constaté qu'on pouvait remédier à cet inconvénient à condition de travailler avec des réducteurs présentant une surface spécifique, mesurée après pyrolyse à 1000°C, comprise entre 20 et 40 m²/g.

La méthode de contrôle de la surface spécifique des réducteurs est exclusivement une mesure par la technique B.E.T. effectuée sur le réducteur dans sa granulométrie d'origine après 24 h de séchage en étuve à 110°C, puis dégazage sous vide. L'adsorption est réalisée à 20°C avec du gaz ammoniac sec ; l'équilibre entre la phase adsorbée et la phase gazeuse s'établissant avec une cinétique lente, chaque mesure est faite après 24 h d'attente.

Cette méthode est directement applicable au cokes et aux charbons de bois ; pour les houilles et charbons fossiles, une cokéfaction préalable à 1000°C est indispensable.

Cette méthode donne les résultats suivants :
- sur les charbons de bois : environ 125 m²/g
- sur les cokes les plus réactifs connus : de 80 à 140 m²/g
- sur les houilles cokéfiables : environ 80 m²/g
- sur les cokes de haut fourneau : de 40 à 50 m²/g
- sur les charbons non cokéfiables : de 20 à 40 m²/g
- sur les cokes de pétrole : de 15 à 25 m²/g
- sur les cokes de brai : de 1 à 4 m²/g

Dans un four de réduction dimensionné géométriquement et réglé électriquement selon les règles classiques connues de l'homme de l'art, et en utilisant des réducteurs de surface spécifique d'environ 80 m²/g, la fabrication du silicium s'accompagne d'une formation importante de fumées, de l'ordre de 350 kg de fumées par tonne de silicium, et d'une formation de carbure de silicium de l'ordre de 12 kg par tonne de silicium. Cette fabrication s'accompagne également de la formation d'environ 50 kg de laitier par tonne de silicium, ce qui en général suffit pour entraîner à la coulée le carbure de silicium formé.

Avec des réducteurs de moindre surface spécifique et donc moins réactifs, la situation se dégrade rapidement. Le taux de fumées augmente vers des valeurs élevées ; le taux de carbure de silicium augmente également et comme le laitier produit ne suffit plus à son évacuation, il y a accumulation dans le four et rétrécissement du volume utile du four, ce qui accélère la dégradation de la situation.

La demanderesse a constaté qu'on pouvait cependant utiliser des réducteurs à surface spécifique plus faible, dans le domaine 20 à 40 m²/g, à condition de modifier les paramètres de fonctionnement habituels du four à silicium. Cette modification consiste à baisser la puissance électrique Pₑ appliquée au four et à augmenter le diamètre des électrodes Dₒ. En effet, la cinétique imposée au système chimique évolue grosso modo comme le rapport Pₑ/Dₒ³, ou plus exactement comme le tiers de ce rapport, les fours triphasés comportant trois électrodes, alors que son aptitude à suivre la cinétique imposée évolue comme la surface spécifique moyenne pondérée S du mélange de réducteurs utilisés. Cette surface moyenne pondérée s'évalue en faisant la somme Σ ( αᵢSᵢ) sur les n réducteurs utilisés, αᵢ représentant le pourcentage de carbone fixe apporté par le i ième réducteur entrant dans la composition du mélange de réducteurs. On peut donc compenser la baisse de S par une baisse de Pₑ et une augmentation de Dₒ, tout en acceptant un taux de fumées plus élevé que de coutume, mais très inférieur à ce qu'il serait en maintenant Pₑ et Dₒ constants.

Alors qu'avec les paramètres habituels de réglage des fours, une fabrication de silicium requiert une surface spécifique moyenne des réducteurs S > 60 m²/g et un rapport (Pₑ/Dₒ³ )/3 compris entre 4 et 5 MW/m³, on peut utiliser des réducteurs de surface spécifique S comprise entre 20 et 40 m²/g à condition d'avoir un rapport (Pₑ/Dₒ³ )/3 compris entre 2 et 3 MW/m³. Effectuée dans de telles conditions, la réduction carbothermique de la silice s'accompagne d'un rendement bore qui se situe entre 45 et 50% environ.

A ce stade du procédé, le silicium liquide obtenu présente l'analyse suivante :
Fe < 0,30% Ca : 0,5 à 1% Al: 0,3 à 0,5%.
Bore : 1 à 10 ppm Phosphore : 10 à 25 ppm

La relativement basse teneur en phosphore obtenue tient au fait que l'on n'utilise ni bois ni charbon de bois. On peut noter également que les matières premières à basses teneurs en bore sont également le plus souvent à basses teneurs en titane.

L'étape suivante consiste en un traitement d'affinage. Le silicium liquide élaboré au four est coulé en poches, où il est l'objet d'un affinage oxydant effectué par injection d'oxygène ou de chlore. Au terme de cet affinage, le silicium liquide obtenu présente l'analyse suivante :
Fe < 0,3% Ca < 0,1% Al < 0,3%.
Bore : 1 à10 ppm Phosphore : 10 à 25 ppm

Les teneurs en fer et titane sont peu affectées par cet affinage.

La poche de silicium liquide est ensuite traitée sous pression réduite avec simultanément injection de gaz neutre, par exemple de l'argon ; on vise à maintenir au dessus du silicium liquide une pression inférieure à 100 Pa, et de préférence inférieure à 30 Pa. La descente du titre en phosphore suit une exponentielle décroissante du type : P = Po Exp (- kt ). En exprimant « t » en minutes, on obtient une valeur de k d'environ 0,07.

Il suffit de choisir le temps de traitement en fonction de la teneur en phosphore du silicium à traiter. Un traitement de 15 minutes peut suffire pour obtenir un silicium liquide titrant moins de 10 ppm de phosphore. Ce traitement contribue également à faire baisser la teneur en oxygène, qui est partiellement éliminé sous forme de SiO.

Les autres éléments sont peu affectés par ce traitement, qui en particulier ne permet pas de baisser significativement la teneur en calcium, métal pourtant assez volatil.

Enfin la dernière étape du procédé consiste à solidifier le silicium à vitesse contrôlée, par exemple dans un four à réverbère, de façon à provoquer une ségrégation des impuretés qui se concentrent dans le liquide résiduaire. En séparant solide et liquide à mi-solidification environ, on obtient de 48 à 52% de silicium solide à moins de 500 ppm d'éléments métalliques, et un silicium liquide résiduaire pouvant contenir de 0,5 à 1% d'éléments métalliques.

Le refroidissement de la masse coulée est contrôlé pour limiter la vitesse de progression du front, qui doit rester inférieure à 2.10⁻⁵ m/s, et de préférence à 10⁻⁵ m/s.

On peut procéder ensuite à une refusion par lots sous atmosphère neutre, par exemple d'argon, au four électrique, de préférence à induction, du silicium solide à moins de 500 ppm d'éléments métalliques , en creuset chaud classique, soit en carbone, en graphite ou en carbure de silicium, soit avec un garnissage réfractaire constitué de silice frittée. Le générateur électrique alimentant le four à induction travaille à des fréquences dépendant du diamètre du creuset, et typiquement comprises entre 500 et 5000 Hz. Un pied de bain est conservé après chaque coulée pour faciliter le redémarrage de l'opération suivante.

On procède ensuite à la coulée sous atmosphère inerte contrôlée dans une lingotière où est réalisée une seconde opération de solidification ségrégée ; le refroidissement de la masse coulée est contrôlé pour, à ce stade du procédé, limiter la vitesse de progression du front qui doit rester inférieure à 10⁻⁵ m/s et de préférence inférieure à 5.10⁻⁶ m/s.

Le niveau de pureté du silicium solide séparé dépend du rendement choisi en éliminant une fraction de silicium liquide moins ou plus importante selon que l'on coule le silicium liquide résiduaire après un temps de maintien plus ou moins long.

Au terme de cette seconde ségrégation, on peut ainsi obtenir un silicium solide à moins de 300 ppm d'impuretés métalliques, représentant 80 à 86% de la masse traitée lors de cette seconde ségrégation, la proportion de silicium liquide restant, enrichi en éléments métalliques, se situant entre 14 et 20%.

L'ensemble de la filière permet alors de préparer environ 48 à 52% de silicium contenant de 0,5 à 1% d'impuretés métalliques, 7 à 10% de silicium contenant de 500 à 1500 ppm d'impuretés métalliques, et 40 à 43% de silicium de moyenne pureté selon l'invention.

La consommation d'énergie est d'environ 2000 kWh/t de silicium de moyenne pureté, à laquelle il faut ajouter quelques 16000 kWh/t nécessaires à l'élaboration du matériau de base sur un four de taille industrielle, ce qui donne un total de l'ordre de 18000 kWh/t pour le silicium de moyenne pureté obtenu.

Le silicium moyenne pureté obtenu par ce procédé présente la composition suivante :
Bore : 1 à 10 ppm; Phosphore/Bore entre 0,5 et 1,5;
Total des impuretés : 100 à 400 ppm,
Total des impuretés métalliques : 30 à 300 ppm, Fe : 10 à 200 ppm,
Carbone : 20 à 50 ppm ; Oxygène : 50 à 100 ppm ;
Calcium :5 à 30 ppm ; Aluminium : 5 à 30 ppm; Titane : 2 à 20 ppm.

On peut encore améliorer la qualité du silicium obtenu en recoulant davantage de liquide lors de la première ou de la seconde ségrégation au détriment du rendement et obtenir par exemple, avec un rendement 2/3 de solide et 1/3 de liquide, un silicium répondant à l'analyse :
Bore : 1 à 10 ppm ; Phosphore/Bore entre 0,5 et 1,5;
Total des impuretés : 100 à 300 ppm,
Total des impuretés métalliques : 30 à 200 ppm, Fe : 10 à 40 ppm,
Carbone : 10 à 30 ppm; Oxygène : 20 à 50 ppm;
Calcium :5 à 20 ppm ; Aluminium 5 à 20 ppm ; Titane : 2 à 10 ppm.

L'ensemble de la filière permet alors de séparer sur une production de silicium carbothermique : environ 48 à 52% de silicium contenant de 0,5 à 1% d'impuretés métalliques, 16 à 18 % de silicium contenant de 500 à 1500 ppm d'impuretés métalliques, et 32 à 34% de silicium selon l'invention.

### Exemples

### Exemple 1

Plusieurs essais de réduction de la silice par carbothermie ont été effectués sur un four de 100 kW fonctionnant en courant continu à 5 kA, avec une électrode précuite en carbone de diamètre 350 mm, soit avec une densité de puissance calculée 1/3 Pₑ/Dₒ³ de 2,3 MW/ₘ³.

Un essai avec un coke de brai de granulométrie comprise entre 2 et 7 mm présentant à l'oeil nu des macroporosités importantes, mais ayant donné par la méthode BET à l'ammoniac une surface spécifique de 2 m²/g, s'est terminé de façon catastrophique par le blocage complet du four en moins de 48 h par accumulation de SiC solide.

Une série d'essais avec différents cokes de pétrole ont permis de situer vers 20 m²/g le seuil de réactivité nécessaire pour faire marcher le four de façon pérenne.

### Exemple 2

La suite des essais a été conduite sur un four triphasé de 100 kW équipé d'électrodes précuites de diamètre 250 mm.

Les analyses des éléments basses teneurs, ont été faites par ICP (inducted coupled plasma).

La charge du four était constituée :
- d'un lot de quartz pour lequel la teneur en bore était de 3 ppm,
- de coke de pétrole en calibre de 6 à 12 mm et de surface spécifique 27 m²/g, pour lequel la teneur en bore était inférieure au minimum décelable (0,5 ppm).

Réglé avec un C₃ = 1 / Pₑ^{2/3} de 9,5 ( I est l'intensité en kA dans les électrodes, C₃ la constante de réglage du four), ce four donne habituellement un rendement thermique de 45% contre 75 à 85% pour un four industriel dans la gamme de 10 MW à 20 MW. Les résultats ont été les suivants :
Energie : 29300 kWh/t, ce qui donnerait 16470 kWh/t pour un rendement thermique de 80%.
Consommation de silice : 3680 kg/t.
Analyse du silicium sur la production brute de four:
   Bore : 5 ppm, Phosphore : 18 ppm.

Compte tenu de la petite taille du four, la production a été coulée en lingotières et récupérée à l'état solide. Cette production a été rassemblée, puis refondue dans un four à induction de 800 kW, où elle a fait l'objet d'un affinage oxydant par injection d'oxygène au moyen d'une canne graphite, ce qui a permis d'atteindre la composition :
Fe<0,24% Ca<0,09% Al<0,12% Ni : 38 ppm
Total des impuretés métalliques < 0,50%
Bore : 5 ppm
Phosphore : 18 ppm

Le contenu du four à induction a ensuite été versé dans une poche préchauffée au moyen d'un brûleur à gaz. 275 kg ont ainsi été versés dans cette poche, qui a ensuite été placée sous cloche pour un traitement sous vide avec simultanément injection d'argon par le fond à travers une brique poreuse. La durée du traitement a été de 14 minutes ; la pression de gaz au-dessus du métal en fusion a été mesurée à 30 Pa.

Après traitement, la teneur en phosphore a été mesurée à 7 ppm.

Le contenu de la poche a ensuite été versé dans une lingotière en silice frittée équipée d'un bec de coulée. Cette lingotière, d'une surface de 1 m², a été placée dans un four à réverbère chauffé électriquement au moyen de barreaux en graphite servant de résistances, les fuites thermiques du four se faisant principalement par la sole. La puissance du four a été ajustée à 40 kW pour obtenir une solidification de 50% du silicium en environ 1,25 h. Après 75 minutes d'attente, le liquide restant dans la lingotière a été coulé par le bec et a donné un lingot de 137 kg.

Le silicium solide restant en lingotière, d'une masse de 135 kg, a donné à l'analyse :
Fer = 300 ppm ; Calcium:25ppm; Aluminium : 12 ppm ; Titane : 6 ppm ;
Bore 5 ppm ; Phosphore : 7 ppm ; Carbone : 100 ppm ; Oxygène : 800 ppm.

L'opération a été refaite pour disposer d'une quantité de silicium suffisante pour refaire une opération complète de refusion et solidification ségrégée au four de 800 kW. La puissance du four a été maintenue à 50 kW. La coulée du liquide résiduaire a été réalisée après 4 heures d'attente. La masse coulée a donné un lingot de 85 kg, alors que la masse de silicium solidifiée récupérée a été de 183 kg.

Le silicium solide obtenu après cette seconde ségrégation a donné à l'analyse :
Fer = 35 ppm ; Calcium : 17 ppm ; Aluminium : 14 ppm ; Titane : 4 ppm ;
Bore 5 ppm ; Phosphore : 7 ppm ; Carbone : 25 ppm ; Oxygène : 100 ppm.

## Revendications

1. Procédé d'élaboration de silicium de moyenne pureté destiné à servir de matière première dans la fabrication du silicium de qualité photovoltaïque ou électronique, comportant:
- l'élaboration par réduction carbothermique au four électrique à arc submergé de silicium liquide à basse teneur en bore, en utilisant des réducteurs à teneur en bore < 2 ppm et présentant une surface spécifique moyenne pondérée S comprise entre 20 et 40 m²/g, la densité de puissance utilisée, exprimée par le rapport ( Pₑ/Dₒ³)/3, étant comprise entre 2 et 3 MW/m³,
- l'affinage du silicium liquide à l'oxygène ou au chlore,
- le traitement du silicium liquide sous pression réduite entre 10 et 100 Pa avec injection de gaz neutre,
- une solidification ségrégée.

2. Procédé selon la revendication 1, **caractérisé en ce que** la solidification ségrégée est suivie d'une refusion de la fraction solide obtenue et d'une seconde solidification ségrégée.

3. Procédé selon l'une des revendications 1 ou 2, **caractérisé en ce que** la première solidification ségrégée est conduite avec une vitesse de progression du front de solidification inférieure à 2.10⁻⁵ m/s.

4. Procédé selon l'une des revendications 2 ou 3, **caractérisé en ce que** la seconde solidification ségrégée est conduite avec une vitesse de progression du front de solidification inférieure à 10⁻⁵ m/s.

5. Procédé selon la revendication 4, **caractérisé en ce que** la vitesse de progression du front de solidification est inférieure à 5.10⁻⁶ m/s.

6. Procédé selon l'une des revendications 1 à 5, **caractérisé en ce que** les opérations de solidification ségrégée sont faites dans un four à réverbère.

7. Procédé selon l'une des revendications 2 à 6, **caractérisé en ce que** la refusion est mise en oeuvre dans un four à induction.

8. Procédé selon l'une des revendications 6 ou 7, **caractérisé en ce que** les creusets de fours électriques mis en oeuvre pour la refusion du silicium sont en silice, en carbone, en graphite ou en carbure de silicium.

## Claims

1. Process for smelting medium-purity silicon intended for use as raw material in the manufacture of silicon of photovoltaic or electronic quality, comprising:
- the smelting of liquid silicon with a low boron content by carbothermal reduction in a submerged-arc electric furnace using reducing agents having a boron content of < 2 ppm and having a weighted-average specific surface area s of between 20 and 40 m²/g, the power density used, expressed by the ratio (Pₑ/Dₒ³)/3, being between 2 and 3 MW/m³;
- the oxygen-refining or chlorine-refining of the liquid silicon;
- the treatment of the liquid silicon under reduced pressure of between 10 and 100 Pa with injection of inert gas; and
- segregated solidification.

2. Process according to Claim 1, **characterized in that** the segregated solidification is followed by remelting of the solid fraction obtained and then a second segregated solidification.

3. Process according to either of Claims 1 and 2, **characterized in that** the first segregated solidification is carried out with a rate of advance of the solidification front of less than 2 x 10⁻⁵ m/s.

4. Process according to either of Claims 2 and 3, **characterized in that** the second segregated solidification is carried out with a rate of advance of the solidification front of less than 10⁻⁵ m/s.

5. Process according to Claim 4, **characterized in that** the rate of advance of the solidification front is less than 5 x 10⁻⁶ m/s.

6. Process according to one of Claims 1 to 5, **characterized in that** the segregated solidification operations are carried out in a reverberatory furnace.

7. Process according to one of Claims 2 to 6, **characterized in that** the remelting is carried out in an induction furnace.

8. Process according to either of Claims 6 and 7, **characterized in that** the electric furnace crucibles used for remelting the silicon are made of silica, carbon, graphite or silicon carbide.

## Patentansprüche

1. Verfahren zur Verarbeitung von Silizium mittlerer Reinheit, das dazu bestimmt ist, als Ausgangsstoff bei der Herstellung von Silizium in fotovoltaischer oder elektronischer Güte zu dienen, Folgendes umfassend:
- Verarbeiten von flüssigem Silizium mit niedrigem Borgehalt durch carbothermische Reduktion im Elektro-Lichtbogenofen unter Verwendung von Reduktionsmitteln mit einem Borgehalt von < 2 ppm, die eine mittlere spezifische gewichtete Oberfläche S von zwischen 20 und 40 m²/g aufweisen, wobei die verwendete Leistungsdichte, die durch das Verhältnis (Pₑ/Dₒ³) ausgedrückt wird, zwischen 2 und 3 MW/m³ beträgt,
- Affinieren des flüssigen Siliziums mit Sauerstoff oder Chlor,
- Behandeln des flüssigen Siliziums unter reduziertem Druck zwischen 10 und 100 Pa mit Einspritzen von Neutralgas,
- Seigerungserstarrung.

2. Verfahren nach Anspruch 1, **dadurch gekennzeichnet, dass** auf die Seigerungserstarrung ein Wiederaufschmelzen der erhaltenen festen Fraktion und eine zweite Seigerungserstarrung folgt.

3. Verfahren nach einem der Ansprüche 1 oder 2, **dadurch gekennzeichnet, dass** die erste Seigerungserstarrung mit einer Fortschrittsgeschwindigkeit der Erstarrungsfront unter 2·10⁻⁵ m/s erfolgt.

4. Verfahren nach einem der Ansprüche 2 oder 3, **dadurch gekennzeichnet, dass** die zweite Seigerungserstarrung mit einer Fortschrittsgeschwindigkeit der Erstarrungsfront unter 10⁻⁵ m/s erfolgt.

5. Verfahren nach Anspruch 4, **dadurch gekennzeichnet, dass** die Fortschrittsgeschwindigkeit der Erstarrungsfront unter 5·10⁻⁶ m/s liegt.

6. Verfahren nach einem der Ansprüche 1 bis 5, **dadurch gekennzeichnet, dass** die Seigerungserstarrungsabläufe in einem Flammofen stattfinden.

7. Verfahren nach einem der Ansprüche 2 bis 6, **dadurch gekennzeichnet, dass** das Wiederaufschmelzen in einem Induktionsofen durchgeführt wird.

8. Verfahren nach einem der Ansprüche 6 oder 7, **dadurch gekennzeichnet, dass** die Schmelztiegel der Elektroöfen, die zum Wiederaufschmelzen des Siliziums eingesetzt werden, aus Siliziumoxid, Kohlenstoff, Grafit oder Siliziumcarbid sind.
